Europäisches Patentamt

European Patent Office

Office européen des brevets

(19)

(11) Publication number: **0 131 464**
**B1**

(12) **EUROPEAN PATENT SPECIFICATION**

(45) Date of publication of patent specification: 07.09.88

(51) Int. Cl.⁴: $H\ 01\ L\ 27/02$

(21) Application number: 84304669.9

(22) Date of filing: 09.07.84

(54) Masterslice semiconductor device.

(30) Priority: 09.07.83 JP 125290/83

(43) Date of publication of application:
16.01.85 Bulletin 85/03

(45) Publication of the grant of the patent:
.07.09.88 Bulletin 88/36

(84) Designated Contracting States:
DE FR GB

(56) References cited:
FR-A-2 315 804
FR-A-2 365 883

JAPANESE JOURNAL OF APPLIED PHYSICS,
vol. 19, suppl. 19-1, 1980, pages 203-206,
Tokyo, JP; M. ASHIDA et al.: "A 3000-gate
CMOS masterslice LSI"

(73) Proprietor: FUJITSU LIMITED
1015, Kamikodanaka Nakahara-ku
Kawasaki-shi Kanagawa 211 (JP)

(72) Inventor: Sato, Shinji c/o Fujitsu Limited
Patent Department 1015 Kamikodanaka
Nakahara-ku
Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

EP 0 131 464 B1

## Description

The present invention relates to a semiconductor device of a large scale integration (LSI) and, more specifically, relates to a so-called masterslice semiconductor device fabricated from a large number of basic cells arranged along both rows and columns of a semiconductor substrate.

Masterslice semiconductor technology is proposed as a means for providing custom-tailored large scale integration (LSI) semiconductor circuit at a low cost and within a short turnaround time. That is, a large number of basic cells each including transistors and resistors, which are formed in a semiconductor chip in advance and, are thereafter interconnected by the use of masks having wiring patterns necessary for realizing a functional circuit to meet each customer's specific requirements.

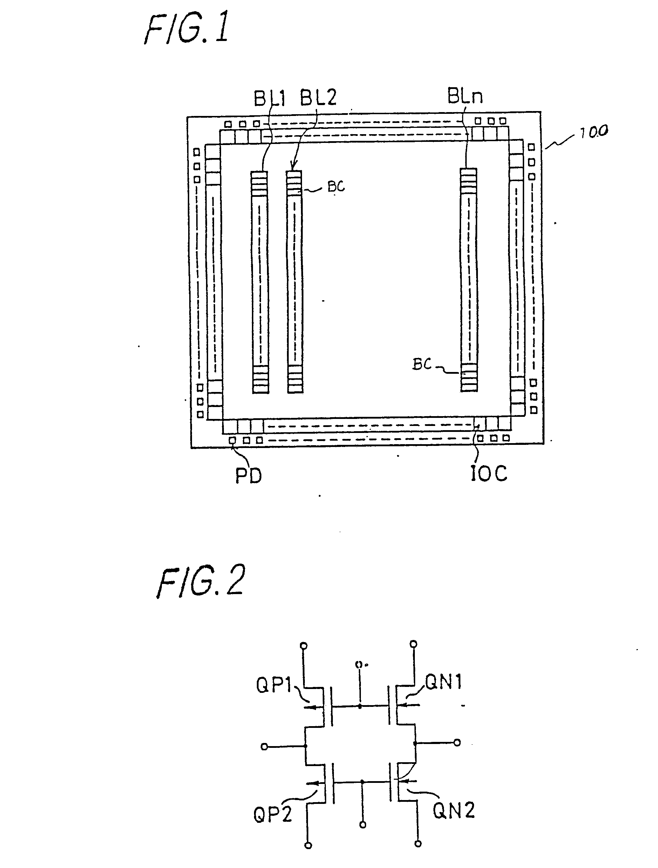

Figure 1 is a plan view showing the conventional bulk pattern of a gate array formed by use of masterslice technology. As illustrated in Figure 1, on a semiconductor substrate chip 100, basic cells BC are arranged in columns to constitute basic cell arrays $BL_1$, $BL_2$,...$BL_n$. Each of the basic cells BC is, in general, comprised of at least a pair of p-channel and n-channel MIS (Metal Insulator Semiconductor) transistors (to be simply referred to as p-channel and n-channel transistors, hereinafter).

The basic cell arrays are arranged with specified spacing therebetween in the row direction. At the periphery of the chip 100, there is a pad region, which is allotted for a plurality of pads, PD, used as terminals for external circuitry and an input/output (I/O) cell region, which is allotted for a plurality of I/O cells, IOC, each containing an input/output (I/O) circuit (not shown). As described later, each space between adjacent basic cell arrays is used for distributing wiring lines interconnecting the basic cells in a basic cell array and/or the basic cells in different basic cell arrays.

Figure 2 is an equivalent circuit diagram of an example of conventional basic cell comprised of two pairs of p-channel and n-channel transistors. In Figure 2, each pair of a p-channel transistor and an n-channel transistor, i.e. the first pair comprising a p-channel transistor $QP_1$ and an n-channel transistor $QN_1$, the second pair comprising a p-channel transistor $QP_2$ and an n-channel transistor $QN_2$, have a single common gate, and the p-channel transistors $QP_1$ and $QP_2$ have a single common source or drain, while the n-channel transistors $QN_1$ and $QN_2$ have a single common source or drain.

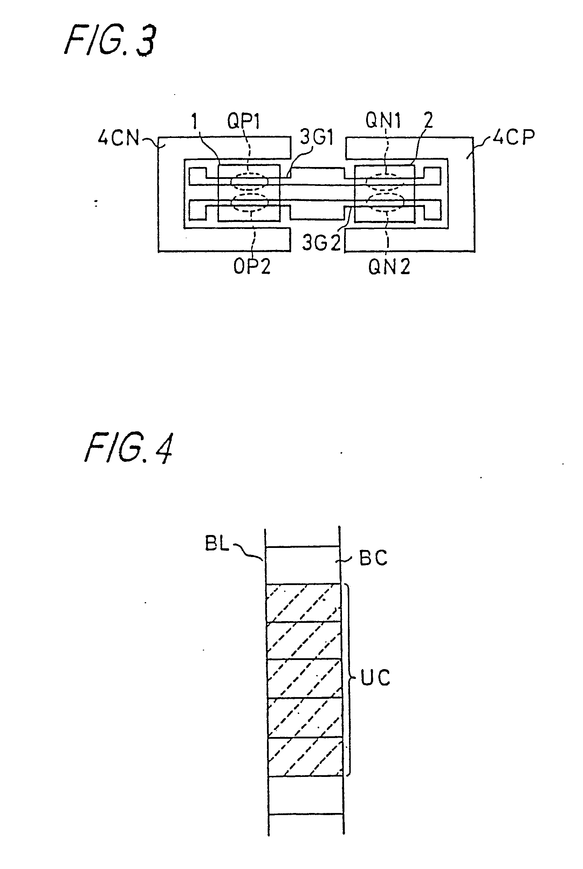

Figure 3 is a plan view illustrating an exemplary bulk pattern of the basic cell embodying the circuit shown in Figure 2. A masterslice semiconductor device comprised of basic cells each having such a bulk pattern has been disclosed in the United States Patent 4,412,237 issued October 25, 1983, for example.

In Figure 3, like reference characters designate like or corresponding parts in Figure 2, and further, reference numerals 1 and 2 designate a p-type region and an n-type region, respectively, both $3G_1$ and $3G_2$ represent polysilicon gate electrodes, and 4CP and 4CN denote a p-type contact region and an n-type contact region, respectively. The p-type region 1 is for constituting the sources and drains of the p-channel transistors $QP_1$ and $QP_2$, while the n-type region 2 is for constituting the sources and drains of the n-channel transistors $QN_1$ and $QN_2$. Each of the contact regions 4CP and 4CN provided with a relatively low resistivity is used as an electrode for keeping portions of the semiconductor substrate at specified potentials.

In masterslice semiconductor technology, an LSI circuit is comprised of a number of elementary circuits including 2-input NAND gates, 2-input NOR gates and/or flip-flop circuits. Each of the elementary circuits is organized by using a single or a plurality of basic cells such as shown in Figures 2 and 3. The area occupied by the basic cells constituting each elementary circuit is referred to as a unit cell. Previously, each of such unit cell is comprised of basic cells successively arranged in a same basic cell array. Figure 4 is a conceptual diagram presenting the previous configuration of a unit cell UC (the hatched area) in a basic cell array BL. The basic cells in the unit cell UC are interconnected by use of so-called double-layer aluminum metallization technology, wherein aluminum wiring lines interconnecting the basic cells belonging to the unit cell are exclusively permitted to pass through over the region occupied by the basic cells.

Interconnections among the unit cells is also accomplished by use of double-layer aluminum metallization technology, however, the aluminum wiring lines for this purpose must be formed in the space between the adjacent basic cell arrays. This limitation is imposed by the performance of the CAD (Computer Aided Design) system employed for designing the layout of the circuit network of a masterslice semiconductor device.

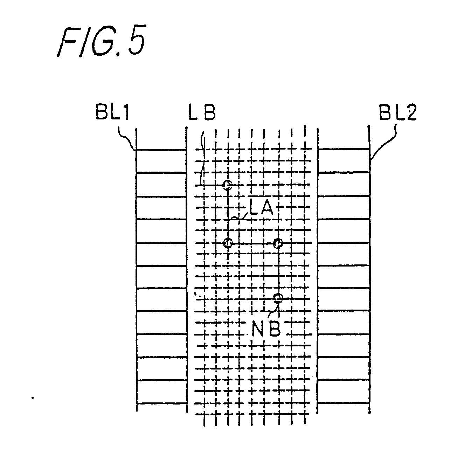

These wiring lines formed in the space between adjacent basic arrays are assumed to be arranged on a virtual grid having a constant pitch Figure 5 is a plan view showing an exemplary layout of an aluminum wiring line interconnecting two adjacent basic cell arrays $BL_1$ and $BL_2$. In Figure 5, the wiring line consists of segments indicated by LA and LB laid on the virtual grid situated in the space between two adjacent basic arrays $BL_1$ and $BL_2$. The virtual grid is, of course, not apparent in the actual pattern but only exists as a logical image in the process of CAD. If assumed that there are nine grid lines along the longitudinal direction of the basic cell arrays $BL_1$ and $BL_2$, nine wiring lines such as LA can be accommodated in the space. Such space is referred to as a wiring region of nine channels. This the same as to the grid lines in the transverse direction.

According to the double-layer aluminum metallization as described above, each segment LA extending along the longitudinal direction of the basic cell arrays is fabricated from a first wiring layer, while each segment LB extending perpendicularly to the longitudinal direction of the basic cell arrays is fabricated from a second wiring layer, each wiring layer is formed of aluminum, in general. The segments LA and LB are connected to each other at each cross-over point marked with a double-circle, via a through-hole formed in an insulating layer therebetween. Thus, interconnection between the basic cells in the two adjacent basic cell arrays is completed.

As mentioned before, in the previous masterslice technology, the basic cells constituting a unit cell must be those belonging to a same basic cell array. That is, a unit cell must be one dimensional in terms of the arrangement of the basic cells. This is mainly due to the performance of the present CAD system employed for the network design of the masterslice semiconductor device. To manufacture a final masterslice semiconductor device within a required short turnaround time, it is necessary to minimize the design parameters which are defined in the CAD system. And if a unit cell were defined to be two dimensional in terms of the arrangement of the basic cells, the number of the parameters should be too large to finish the network design in a desired period. Therefore, each unit cell is formed in one basic cell array, and interconnections between adjacent basic cell arrays is conducted on unit cell basis, not on basic cell basis.

As the result of the restriction that a unit cell must be one dimensional in the sense as mentioned above, both of two kinds of the wiring lines, the first kind for interconnecting basic cells in a unit cell, and the second kind for interconnection among unit cells, become long, and further the variety and the scale of unit cells are limited by the number of the channels available in the space between adjacent basic cell arrays. As a wiring line becomes longer, the propagation delay of the signals in the circuit network of the masterslice semiconductor device increases because of the increase in the parasitic capacity of the wiring line. When such propagation delay is significant, the delay is usually compensated by providing a means such as a block-buffer circuit which has high driving capability, however, a number of basic cells must be allotted for constituting the block-buffer circuit. For example, eleven the basic cells, each having the configuration as shown in Figure 2, are necessary for constituting one block-buffer circuit. Therefore, in case where it is necessary to implement a number of block-buffer circuits, the basic cells available for constituting desired unit cells are decreased. As a result, the variety of circuits obtainable by use of the masterslice technology is also limited.

According to the present invention there is provided a masterslice semiconductor device, with or without wiring patterns, comprising:

a plurality of first basic cell arrays arranged in parallel, each of said first basic cell arrays having a plurality of first basic cells each including at least one transistor;

a plurality of second basic cell arrays each arranged between two adjacent said first basic cell arrays, such that a second basic cell in the second basic cell array is capable of functionally interconnecting the first basic cell arrays allowing the constitution of a two-dimensional unit cell, each of said second basic cell arrays having a plurality of second basic cells having a size larger than that of said first basic cells each including at least one transistor which has a higher driving capability than the said transistor of a first basic cell, portions of the said second basic cells being also able to serve as the region for distributing the wiring lines interconnecting unit cells.

An embodiment of the present invention can provide a masterslice semiconductor device comprised of basic cells having a bulk pattern which permits unit cells to range over plural basic cell arrays, so that it is possible to constitute a unit cell beyond the space between adjacent basic cell arrays. That is, a unit cell may be two-dimensional in terms of the arrangement of basic cells, and the problems of propagation delay of signals and other inconveniences arised from the above-mentioned restriction in the previous unit cell configuration can be mitigated or eliminated and freedom in circuit design of a masterslice semiconductor device can be substantially increased.

Regions corresponding to second basic cells can be used for distribution of wiring lines. If the cells are made ineffective the whole of the region corresponding to the cells can be used for wiring.

An embodiment of the present invention can provide a masterslice semiconductor device having a high propagation speed of signals.

In an embodiment of the present invention a masterslice semiconductor device is constituted by incorporating second type basic cell arrays into each space between two adjacent first basic cells arrays comprising the basic cells substantially the same as in the previous masterslice semiconductor devices. Each of the second basic cell arrays is comprised of second basic cells having a relatively larger size and higher power capacity p-channel and/or n-channel transistors when compared with the first basic cell arrays comprised of basic cells each having p-channel and/or n-channel transistors of relatively smaller size and lower driving capability. The second basic cells in each second basic cell array are arranged in parallel to the longitudinal direction of the first basic cell arrays and can afford to contain wiring lines interconnecting the unit cells in a single first basic cell array and/or in two adjacent first basic cell arrays. And further, second basic cells in a second basic cell array can constitute a unit cell in conjunction with the first basic cells in any adjacent first basic cell arrays, if necessary.

In the CAD of a circuit network of a masterslice semiconductor device embodying the present invention, the layout of the wiring lines to be laid over the space between the adjacent first basic cell arrays, in other words, the second basic cell array, can be accomplished without particular modifications to the CAD system, while each of the unit cells can be two dimensional in terms of the arrangement of basic cells as far as the unit cell comprises at least one of the second basic cells. As a result, the number and each length of the wiring lines interconnecting the unit cells are decreased, hence the propagation delay of signals can be maintained in a lower level, and the variety of unit cell constructions in the masterslice semiconductor device is increased.

Reference is made, by way of example, to the accompanying drawings, in which:

Figure 1 is a plan view showing a previous bulk pattern of a gate array LSI formed by use of master-slice technology;

Figure 2 is an equivalent circuit diagram of an exemplary basic cell BC shown in Figure 1;

Figure 3 is a plan view illustrating the bulk pattern of the basic cell embodying the circuit shown in Figure 2;

Figure 4 is a conceptual diagram presenting the configuration of a unit cell;

Figure 5 is a plan view showing an exemplary layout of double-layer aluminum wiring lines on a virtual grid;

Figure 6(a) is a plan view illustrating a bulk pattern of basic cell arrays according to an embodiment of the present invention;

Figure 6(b) is a partially enlarged plan view illustrating a bulk pattern of basic cell arrays shown in Figure 6(a);

Figure 7 is a plan view illustrating an exemplary bulk pattern of basic cells according to an embodiment of the present invention;

Figure 8 is an equivalent circuit diagram showing an inverter circuit;

Figure 9 is a plan view illustrating the essential portion of a bulk pattern embodying the inverter circuit shown in Figure 8;

Figures 10 and 11 are plan views of a bulk pattern, both for indicating regions for aluminum wiring;

Figure 12 is a circuit diagram including a 2-input NOR gate attached with heavy output load; and

Figure 13 is a plan view of an exemplary bulk pattern of the large sized basic cell, embodying the 2-input NOR gate in the circuit shown in Figure 12.

Throughout the figures, each like reference numeral or character designates like or corresponding parts.

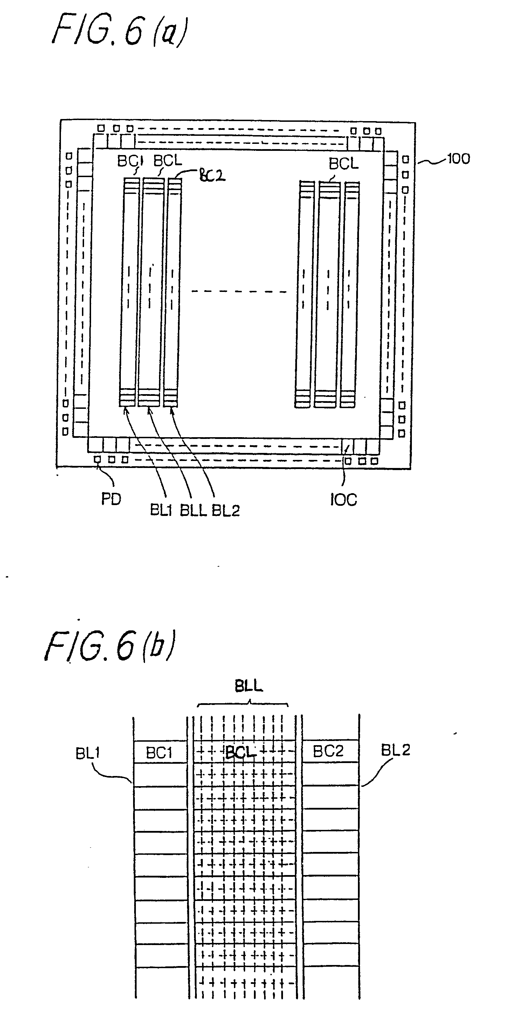

Figure 6(a) is a plan view illustrating the fundamental layout of basic cell arrays in a masterslice semiconductor device embodying the present invention, and Figure 6(b) is a partially enlarged plan view illustrating a bulk pattern of basic cell arrays shown in Figure 6(a). As seen in Figure 6(a), a basic cell array BLL (which is referred to as the second basic cell array hereinafter) comprising a number of large sized basic cells, BCL, is formed between two basic cell arrays $BL_1$ and $BL_2$. The basic cell arrays $BL_1$ and $BL_2$ (which are referred to as the first basic cell arrays hereinafter) are comprised of basic cells $BC_1$, $BC_2$, each of which has a size of substantially same as that of the basic cells in the previous masterslice semiconductor device. As shown in Figure 6(b), a virtual grid the same as shown in Figure 5 is described in the region occupied by the second basic cell array BLL. That is, the wiring lines are distributed on the virtual grid lines as in the previous masterslice semiconductor device.

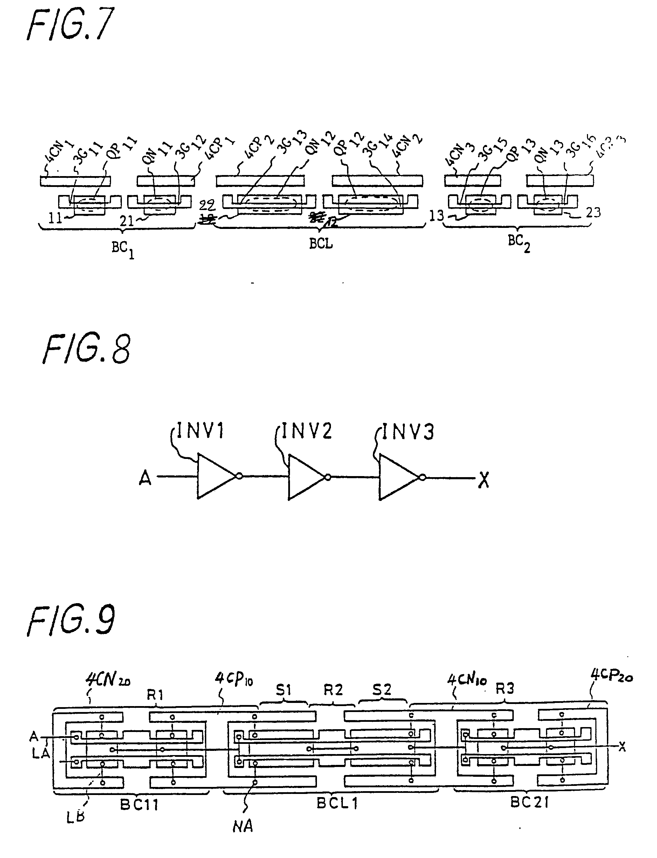

Figure 7 is a plan view illustrating an exemplary bulk pattern of first $BC_1$, $BC_2$ second BCL basic cells according to the embodiment of the present invention. The first basic cells $BC_1$ and $BC_2$ respectively belong to the first basic cell arrays $BL_1$ and $BL_2$, and the second basic cell BCL belongs to the second basic cell array BLL. The region occupied by the second basic cell array BLL is about same as the space for wiring lines interconnecting basic cells in the previous masterslice semiconductor device. In Figure 7, reference numerals 11, 12 and 13 designates respective p-type regions of p-channel transistors $QP_{11}$, $QP_{12}$ and $QP_{13}$, and reference numerals 21, 22 and 23 designate respective n-type regions of the n-channel transistors $QN_{11}$, $QN_{12}$ and $QN_{13}$, and further, each of reference characters $4CP_1$, $4CP_2$ and $4CP_3$ designates a p-type contact region and each of the reference characters $4CN_1$, $4CN_2$ and $4CN_3$ designates an n-type contact region.

As shown by Figure 7, the second basic cell BCL has the same structure as that of the first basic cell $BC_1$ or $BC_2$ in principle, except for the only difference in the dimension along the gate width. That is, the p-channel transistor $QP_{12}$ and the n-channel transistor $QN_{12}$ of the second basic cell BCL respectively have gates $3G_{13}$ and $3G_{14}$ whose widths are larger compared with the respective gates $3G_{11}$ and $3G_{12}$ of the p-channel transistor $QP_{11}$ and n-channel transistor $QN_{11}$ of the first basic cell $BC_1$ and also larger compared with the respective gates $3G_{15}$ and $3G_{16}$ of the p-channel transistor $QP_{13}$ and n-channel transitor $QN_{13}$ of another first basic cell $BC_2$. In the direction along the gate length, the transistors $QP_{12}$ and $QN_{12}$ have the same dimension as those of the transistors $QP_{11}$, $QN_{11}$, $QP_{13}$ and $QN_{13}$. The width ratio of the first basic cell and the second basic cell is, for example, 7:3. In each basic cell the gates of the p-channel and n-channel transistors may be formed to have a single common gate.

Figure 8 is an equivalent circuit diagram showing an inverter circuit. The circuit is comprised of serially connected three inverters $INV_1$, $INV_2$ and $INV_3$, wherein A and X denote an input signal and an ouptut signal, respectively. The inverter circuit shown in Figure 8 is dealt with as a unit cell in the CAD system.

Figure 9 is a plan view illustrating the essential portion of a bulk pattern embodying the inverter circuit, i.e. a unit cell, shown in Figure 8. Each of the basic cells $BC_{11}$, $BCL_1$ and $BC_{21}$ in Figure 9 is comprised of a pair of basic cells $BC_1$, BCL and $BC_2$, respectively of Figure 7. In each of the basic cells $BC_{11}$, $BCL_1$ and $BC_{21}$, the gates of each pair of p-channel transistors and n-channel transistors form a common gate. Also in each of the basic cells $BC_1$, BCL and $BC_2$, the sources or drains of each pair of p-channel transistors occupy a single p-type region and the sources or drains of each pair of n-channel transistors occupy a single n-type region. The adjacent two or four contact regions of same type are united together into single contact region $4CP_{10}$, $4CN_{10}$, $4CP_{20}$ or $4CN_{20}$. In Figure 9, NA indicates contact portions (marked with circles) of aforesaid first aluminum layer wiring lines, LA, and second aluminum layer wiring lines, LB, to the semiconductor substrate. As shown in Figure 9, there are two kinds of regions along the row of the basic cells $BC_1$, BCL and $BC_2$. That is, the one where the aluminum wiring lines LA and LB are distributed and, the other where any aluminum wiring line does not exist. In Figure 9, the former regions are indicated by $R_1$, $R_2$ and $R_3$, while the latter regions are indicated by $S_1$ and $S_2$.

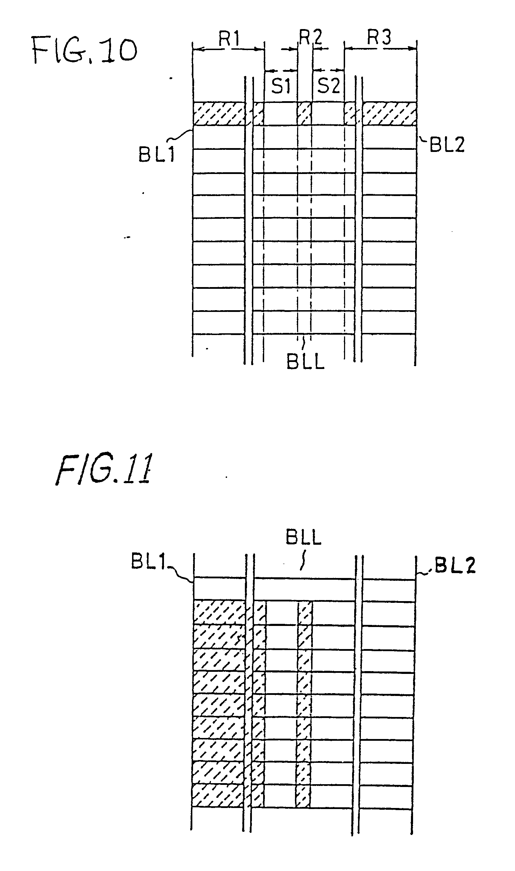

Figure 10 is a plan view illustrating the position of a unit cell as shown by Figure 9 in a bulk pattern same as Figure 6(b). In Figure 10, the hatched regions $R_1$, $R_2$ and $R_3$ are assigned to aluminum layer wiring lines LA and LB distributed within a unit cell. The regions $S_1$ and $S_2$ throughout the bulk pattern can be used for distributing the aluminum layer wiring lines interconnecting unit cells. As obviously seen in Figure 10, a unit cell can be comprised of basic cells in the basic cell arrays $BL_1$, BLL and/or $BL_2$. That is, the unit cell can be two dimensional in terms of the arrangement of the basic cells. This is because that the large sized basic cell in the basic cell array BLL is capable of functionally interconnecting the basic cell arrays $BL_1$ and $BL_2$, and is also able to serve as the region for distributing the wiring lines interconnecting unit cells. Such features can not be provided by the basic cell in the previous masterslice semiconductor device.

The number of channels of the wiring lines to be distributed in the regions $S_1$ and $S_2$ is, of course, decreased into, for example, 70 per cent of the channels in the previous masterslice semiconductor device, so far as the width of the basic cell array BLL is same as that of the space between the adjacent basic cell arrays in the previous device. On the other hand, with the introduction of the two dimensional unit cell, the number of the wiring lines necessary for interconnecting unit cells are comparably reduced. This means that, in the masterslice semiconductor device embodying the present invention, no particular modifications are needed for designing the first basic cell arrays, $BL_1$, $BL_2$...$BL_n$, i.e. the width and the pitch in the arrangement of the first basic cell arrays can be same as those in the prior art. If full number of channels, for instance, are required to be accommodated within a range along a few basic cells of the second basic cell array, the entire region occupied by the relevant basic cells may be used for the wiring lines of the required channels, and the basic cells are made ineffective instead.

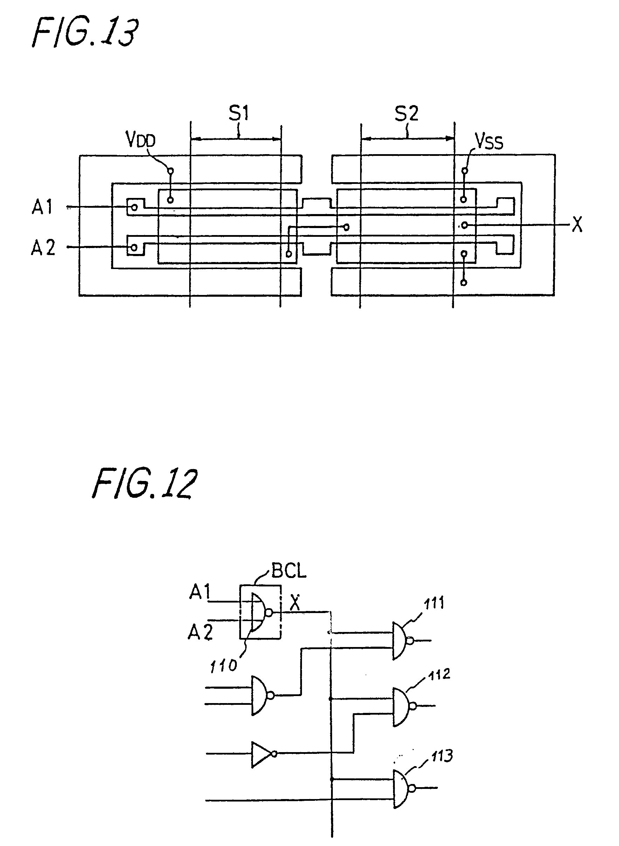

Figure 11 is a plan view illustrating a bulk pattern same as that in Figure 10. Figure 11 represents the case wherein only the transistors arranged in a half column of the basic cell array BL are utilized to constitute unit cells in conjunction with the basic cells in basic cell array $BL_1$. Therefore, the remainder half portion of the basic cell array BLL is exclusively used for the wiring interconnecting unit cells. In the Figure 11, hatched area is the region allotted for the unit cells. This bulk pattern configuration is useful in the case where required channel number for the wiring lines is substantially large.

Figure 12 is a circuit diagram including a 2-input NOR gate burdened with a heavy output load. In Figure 12, $A_1$ and $A_2$ denote two input signals, and BCL indicates a basic cell constituting the 2-input NOR gate. The 2-input NOR gate 110 is attached with three 2-input NAND gates 111, 112 and 113 to its output. When each of the gates is comprised of a unit cell in a masterslice semiconductor device, the output of the 2-input NOR gate 110 is attached with a large the parasitic capacity due to the long wiring lines interconnecting these gates. As a result, propagation delay of the signal $A_1$ and $A_2$ becomes significant in the previous masterslice technology. As a result, a block-buffer circuit is used to be provided for the output of the NOR gate 110. On the other hand, in an embodiment of the present invention, the large sized basic cell in the basic cell array BLL can provide a 2-input NOR gate having high driving power, thereby eliminating need for the block-buffer circuit.

Figure 13 is a plan view of a bulk pattern of the large sized basic cell, embodying the 2-input NOR gate 110 in the circuit shown in Figure 12. In Figure 13, $V_{DD}$ and $V_{SS}$ denote the levels of the positive potential source and the negative potential source, respectively, and $S_1$ and $S_2$ denote the region to be used as wiring regions, as explained above with the reference to Figure 10.

In a masterslice semiconductor device embodying the present invention, the integration density of the transistors on a semiconductor chip is increased thanks to the increment of transistors in the regions which are, in previous devices exclusively used for distributing interconnecting lines. And further, the two dimensional arrangement of basic cells in a unit cell increases availability of transistors for constituting a circuit network of a masterslice semiconductor device, and increases the freedom in the design of the circuit network. Thus, the variety of LSI semiconductor network fabricated by use of masterslice technology can be increased.

The many features and advantages of the present invention are apparent from the detailed description, but it will be recognized by those skilled un the art that modifications and variations may be affected within the present invention. For example, in a masterslice semiconductor device embodying the present invention, the entire region occupied by any of the basic cell arrays comprised of the large sized basic cells can exclusively be used as the wiring region as in the previous device or, on the contrary, a unit cell can be comprised of only the basic cells in the region.

Furthermore, the arrangement of p-channel and n-channel transistors along row may be optional among basic cell arrays, provided that the regularity of the arrangement is kept within each basic cell array. For instance, in a basic cell array, all of the p-channel transistors occupy the lefthand-side positions against n-channel transistors, while in any of other basic cell arrays, vice versa.

**Claims**

1. A masterslice semiconductor device, with or without wiring patterns, comprising:
a plurality of first basic cell (BC1, BC2) arrays (BL1, BL2) arranged in parallel, each of said first basic cell arrays having a plurality of first basic cells each including at least one transistor;
a plurality of second basic cell (BCL) arrays (BLL) each arranged between two adjacent said first basic cell arrays, such that a second basic cell in the second basic cell array (BLL) is capable of functionally interconnecting the first basic cell arrays (BL1, BL2) allowing the constitution of a two-dimensional unit cell, each of said second basic cell arrays having a plurality of second basic cells having a size larger than that of said first basic cells each including at least one transistor which has a higher driving capability than the said transistor of a first basic cell, portions (S1, S2) of the said second basic cells being also able to serve as the region for distributing the wiring lines interconnecting unit cells.

2. A device as claimed in Claim 1, wherein each of said first and second basic cells includes a transistor pair having a p-channel MIS (Metal Insulator Semiconductor) transistor and a n-channel MIS transistor.

3. A device as claimed in Claim 2, wherein in each basic cell the gates of the p-channel and n-channel transistors in the said transistor pair of the cell extend in line with one another in a direction transverse to the direction in which the arrays extend on a semiconductor substrate of the device.

4. A device as claimed in Claim 3, wherein each basic cell includes a further transistor pair having a p-channel MIS transistor and a n-channel MIS transistor arranged so that the gates of the p-channel transistors of the two transistor pairs in the basic cell concerned extend in parallel with one another and so that the gates of the n-channel transistors of the two transistor pairs in the basic cell concerned extend in parallel with one another.

5. A device as claimed in Claim 2, 3 or 4, wherein in each first basic cell, the p-channel and n-channel transistors of the or each transistor pair have a single common gate.

6. A device as claimed in Claim 2, 3 or 4, wherein in each second basic cell, the p-channel and n-channel transistors of the or each transistor pair have a single common gate.

7. A device as claimed in Claim 4, or as claimed in Claim 5 or 6, when raad as appended to Claim 4, wherein, in each first basic cell, sources or drains of the two p-channel transistors of the said transistor pairs of the cell concerned occupy a single p-type region and sources or drains of the two n-channel transistors of the said transistor pairs of the cell concerned occupy a single n-type region.

8. A device as claimed in Claim 4, or as claimed in Claim 5 or 6 when read as appended to Claim 4, or as claimed in Claim 7, wherein, in each second basic cell, sources or drains of the two p-channel transistors of the said transistor pairs of the cell concerned occupy a single p-type region and sources or drains of the two n-channel transistors of the said transistor pairs of the cell concerned occupy a single n-type region.

9. A masterslice semiconductor device as claimed in any preceding claim, with wiring patterns, having wirings disposed on said second basic cells for interconnecting said first basic cells, wherein at least one of the second basic cells in a second basic cell array is utilized to constitute a circuit in conjunction with the first basic cells.

**Patentansprüche**

1. Masterslice-Halbleitervorrichtung, mit oder ohne Verdrahtungsmuster, mit:
einer ersten Vielzahl von Basiszellen-(BC1, BC2)-Arrays (BL1, BL2), die parallel angeordnet sind, von denen jedes genannte erste Basiszellenarray eine Vielzahl von ersten Basiszellen hat, die jeweils wenigstens einen Transistor umfassen;
einer Vielzahl von zweiten Basiszellen-(BCL)-Arrays (BLL), die jeweils zwischen zwei benachbarten der genannten ersten Basiszellenarrays angeordnet sind, so daß eine zweite Basiszelle in dem zweiten Basiszellenarray (BLL) funktionell die ersten Basiszellenarrays (BL1, BL2) miteinander verbinden kann, wobei die Bildung einer zweidimensionalen Einheitszelle erlaubt wird, jedes der genannten zweiten Basiszellenarrays eine Vielzahl von zweiten Basiszellen hat, die ein Größe haben, die größer als diejenige der ersten Basiszellen ist, und die jeweils wenigstens einen Transistor umfassen, der eine höhere Treiberfähigkeit als der genannte Transistor der ersten Basiszelle hat, und Abschnitte (S1, S2) der genannten zweiten Basiszellen fähig sind, als der Bereich zur Verteilung der Verdrahtungsleitungen zu dienen, die die Einheitszellen verbinden.

2. Vorrichtung nach Anspruch 1, bei der jede der genannten ersten und zweiten Basiszellen ein Transistorpaar umfaßt, welches einen p-Kanal-MIS-(Metall- Isolator-Halbleiter)-Transistor und einen n-Kanal-MIS-Transistor hat.

3. Vorrichtung nach Anspruch 2, bei der in jeder Basiszelle die Gates der p-Kanal- und n-Kanal-Transistoren in dem genannten Transistorpaar der Zelle sich in Reihe miteinander in einer Richtung quer zu der Richtung erstrecken, in der sich die Arrays auf dem Halbleitersubstrat der Vorrichtung erstrecken.

4. Vorrichtung nach Anspruch 3, bei der jede Basiszelle ein weiteres Transistorpaar umfaßt, welches einen p-Kanal-MIS-Transistor und einen n-Kanal-MIS-Transistor hat, die so angeordnet sind, daß die Gates der p-Kanal-Transistoren der zwei Transistorpaare in der betreffenden Basiszelle sich parallel zueinander erstrecken, und so, daß die Gates der n-Kanal-Transistoren der beiden Transistorpaare in der betreffenden Basiszelle sich parallel zueinander erstrecken.

5. Vorrichtung nach Anspruch 2, 3 oder 4, bei der in jeder ersten Basiszelle die p-Kanal- und n-Kanal-Transistoren von dem oder jedem Transistorpaar ein einziges gemeinsames Gate haben.

6. Vorrichtung nach Anspruch 2, 3 oder 4, bei der in jeder zweiten Basiszelle die p-Kanal- und n-Kanal-Transistoren von dem oder jedem Transistorpaar ein einziges gemeinsames Gate haben.

7. Vorrichtung nach Anspruch 4, oder nach Anspruch 5 oder 6 in Verbindung mit Anspruch 4, bei der, in jeder ersten Basiszelle, Sourcen oder Drains der beiden p-Kanal-Transistoren des genannten Transistorpaares der betreffenden Zelle einen einzigen p-Typ-Bereich einnehmen, und Sourcen oder Drains der beiden n-Kanal-Transistoren des genannten Transistorpaares der betreffenden Zelle einen einzigen n-Typ-Bereich einnehmen.

8. Vorrichtung nach Anspruch 4, oder nach Anspruch 5 oder 6 in Verbindung mit Anspruch 4, oder nach Anspruch 7, bei der, in jeder zweiten Basiszelle, Sourcen oder Drains der beiden p-Kanal-Transistoren des genannten Transistorpaares der betreffenden Zelle einen einzigen p-Typ-Bereich einnehmen, und Sourcen oder Drains der beiden n-Kanal-Transistoren des genannten Transistorpaares der betreffenden Zelle einen einzigen n-Typ-Bereich einnehmen.

9. Maserslice-Halbleitervorrichtung nach einem der vorhergehenden Ansprüche, mit Verdrahtungsmustern, welche Verdrahtungen haben, die auf den genannten zweiten Basiszellen angeordnet sind, um die genannten ersten Basiszellen miteinander zu verbinden, bei der wenigstens eine der ersten oder zweiten Basiszellen in einem zweiten Basiszellenarray verwendet wird, um in Verbindung mit den ersten Basiszellen eine Schaltung zu bilden.

**Revendications**

1. Composant à semi-conducteur à plaquette-mère avec ou sans configuration de connexion, comportant:

plusieurs premiers réseaux (BL1, BL2) de calcules de base (BC1, BC2) disposés en parallèle, chacun desdits premiers réseaux de cellules de base ayant plusieurs premières cellules de base comprenant chacune au moins un transistor;

plusieurs seconds réseaux (BLL) de cellules de base (BCL) disposés chacun entre deux voisins desdits premiers réseaux de cellules de base de manière qu'une seconde cellule de base dans le second réseau de cellules de base (BLL) soit capable d'interconnecter fonctionellement les premiers réseaux de cellules de base (BL1, BL2) permettant la constitution d'une cellule unitaire bidimensionelle, chacun desdits seconds réseaux de cellules de base comprenant plusieurs secondes cellules de base ayant une dimension supérieure à celle desdites premières cellules de base, comportant chacune au moins un transistor qui a une plus forte capacité d'attaque que ledit transistor d'une première cellule de base, des parties (S1, S2) desdites secondes cellules de base étant également à même de servir de région de distribution des lignes de connexion interconnectant des cellules unitaires.

2. Composant selon la revendication 1, dans lequel chacune desdites premières et desdites secondes cellules de base comporte une paire de transistors, comprenant un transistor MIS (métal-isolant-semi-conducteur) à canal P et un transistor MIS à canal N.

3. Composant selon la revendicaton 2, dans lequel, dans chaque cellule de base, les grilles des transistors à canal P et à canal N dans ladite paire de transistors de la cellule s'étendent en ligne l'une par rapport l'autre dans une direction transversale par rapport à la direction dans laquelle s'étendent les réseaux sur un substrat semi-conducteur du composant.

4. Composant selon la revendication 3, dans lequel chaque cellule de base comporte une autre paire de transistors comprenant un transistor MIS à canal P et un transistor MIS à canal N agencés de manière que les grilles des transistors à canal P des deux paires de transistors dans la cellule de base considérée s'étendent parallèlement entre elles et de manière que les grilles des transistors à canal N des deux paires de transistors dans la cellule de base considérée s'étendent parallèlement entre elles.

5. Composant selon la revendication 2, 3 ou 4, dans lequel, dans chaque première cellule de base, les transistors à canal P et à canal N de la paire ou de chaque paire de transistors ont une seule grille commune.

6. Composant selon la revendication 2, 3 ou 4, dans lequel, dans chaque seconde cellule de base, les transistors à canal P et à canal N de la paire ou de chaque paire de transistors ont une seule grille commune.

7. Composant selon la revendication 4 ou selon la revendication 5 ou 6, lue en annexe à la revendication 4, dans lequel, dans chaque première cellule de base, des sources ou des drains des deux transistors à canal P desdites paires de transistors de la cellule considérée occupent une seule région de type P et des sources ou des drains des deux transistors à canal N desdites paires de transistors de la cellule concernée occupent une seule région de type N.

8. Composant selon la revendication 4 ou selon la revendication 5 ou 6 lue en annexe à la revendication 4 ou sleon la revendication 7, dans lequel, dans chaque seconde cellule de base, des sources ou des drains des deux transistors à canal P desdites paires de transistors de la cellule considérée occupent une seule région de type P et des sources ou des drains des deux transistors à canal N de ladite paire de transistors de la cellule considérée occupent une seule région de type N.

9. Composant à semi-conducteur à plaquette-mère selon l'une quelconque des revendications précédentes avec des configurations de connexions, comprenant des connexions disposées sur lesdites secondes cellules de base pour inter-connecter lesdites premières cellules de base, dans lequel l'une au moins des secondes cellules de base dans un second réseau de cellules de base est utilisée pour constituer un circuit conjointement avec les premières cellules de base.

## FIG.1

BL1  BL2          BLn

100

BC

BC

PD                    IOC

## FIG.2

QP1          QN1

QP2          QN2

1

# FIG. 3

# FIG. 4

# FIG.5

## FIG. 6 (a)

BCI  BCL  BC2  BCL  100

PD  BL1  BLL  BL2  IOC

## FIG. 6 (b)

BLL

BL1  BC1  BCL  BC2  BL2

## FIG.7

## FIG.8

## FIG.9

FIG.10

R1 | R2 | R3

S1 | S2

BL1

BL2

BLL

FIG.11

BLL

BL1

BL2

# FIG.13

# FIG.12